# EUROPÄISCHE PATENTSCHRIFT

(11) **EP 2 548 221 B1**
(45) Veröffentlichungstag und Bekanntmachung des Hinweises auf die Patenterteilung: **01.08.2018**
(21) Anmeldenummer: 11706823.9
(22) Anmeldetag: 07.03.2011
(51) Int. Cl.: H01L 23/06, H01L 51/52, H01L 33/48

(54) **OPTOELEKTRONISCHES BAUELEMENT UND VERFAHREN ZU DESSEN HERSTELLUNG**
OPTOELECTRONIC COMPONENT AND METHOD FOR PRODUCING SAME
COMPOSANT OPTOÉLECTRONIQUE ET SON PROCÉDÉ DE FABRICATION

(30) Priorität: 19.03.2010 DE 102010012039
(43) Veröffentlichungstag der Anmeldung: 23.01.2013
(73) Patentinhaber: OSRAM Opto Semiconductors GmbH, 93055 Regensburg (DE)
(72) Erfinder: KRÄUTER, Gertrud, 93051 Regensburg (DE)
(74) Vertreter: Epping - Hermann - Fischer
(86) Internationale Anmeldenummer: PCT/EP2011/053381
(87) Internationale Veröffentlichungsnummer: WO 2011/113720

(56) Entgegenhaltungen:
- EP-A1- 1 609 835
- WO-A2-2004/027882
- DE-A1- 3 143 452
- DE-A1- 4 414 005
- DE-A1-102008 004 443
- US-A1- 2008 157 113

## Beschreibung

Es wird ein optoelektronisches Bauelement nach dem Anspruch 1 angegeben.

Ein weit verbreitetes Problem von optoelektronischen Bauelementen ist es, ein Material für dieses zu finden, welches den gegebenen Anforderungen entspricht, und sich gleichzeitig noch gut verarbeiten lässt.

Eine Aufgabe von Ausführungsformen der Erfindung besteht darin, sowohl ein geeignetes Material als auch ein geeignetes Verfahren zu finden, sodass das Bauelement die gewünschte Beständigkeit aufweist, und sich das Material dennoch gut verarbeiten lässt.

Die Aufgabe wird durch ein optoelektronisches Bauelement nach dem Anspruch 1 gelöst. Weitere Ausführungsformen des optoelektronischen Bauelements sowie Verfahren zu dessen Herstellung sind Gegenstand weiterer abhängiger Patentansprüche.

Dadurch, dass das Gehäuse einen der oben angeführten Duroplasten umfasst, weist dieses verglichen mit einem Gehäuse, welches aus Thermoplasten geformt ist, deutliche Vorteile auf. Ein Duroplast, welcher im Gegensatz zu einem Thermoplast von Natur aus Quervernetzungen aufweist, sodass ein dreidimensionales Netzwerk ausgebildet wird, weist eine deutlich bessere chemische und physikalische Beständigkeit auf. So verfügt der Duroplast beispielsweise über eine höhere Temperatur- und Strahlungsbeständigkeit sowie über eine höhere mechanische Stabilität. Die größere Oberflächenhärte schützt somit das Gehäuse des optoelektronischen Bauelements vor mechanischer Beschädigung. Die verbesserte thermische Stabilität ermöglicht es, dass zum einen im Fertigungsprozess des optoelektronischen Bauelements selbst höhere Temperaturen zum Einsatz kommen können, wie auch in darauffolgenden Verfahrensschritten, bei denen beispielsweise das optoelektronische Bauelement auf anderen Bauelementen befestigt wird. Die erhöhte Strahlungsbeständigkeit erweist sich vor allem dann als vorteilhaft, wenn das strahlungsemittierende Bauteil einen Wellenlängenbereich emittiert, welcher auch einen UV-Anteil aufweist. Die Beständigkeit gegenüber beispielsweise der Strahlung, welche von dem strahlungsemittierenden Bauteil emittiert wird, vermindert die Alterungserscheinung vor allem des Bereiches des Gehäuses, welches direkt der Bestrahlung ausgesetzt ist. Durch eine höhere Stabilität gegenüber dieser Strahlung kann die Lebenszeit des Gehäuses und somit des gesamten optoelektronischen Bauelements erhöht werden.

Durch den Einsatz von Duroplasten wird auch die chemische Beständigkeit des Gehäuses erhöht, was beispielsweise auch eine erhöhte Beständigkeit gegenüber Lösungsmitteln beinhaltet. Somit kann beispielsweise in der Fertigung des Gehäuses, beziehungsweise des optoelektronischen Bauelements, auf eine größere Zahl von möglichen Lösungsmitteln zurückgegriffen werden.

Ein Problem von Duroplasten war bisher, dass sich diese nur schwierig in einem Spritzguss- oder Spritzpressverfahren verarbeiten lassen.

Dieses Problem wird durch die oben angeführten Duroplasten gelöst. Die hier angegebenen Duroplasten lassen sich bei geeigneter Auswahl der Verfahrensparameter gut in einem Spritzguss- oder Spritzpressverfahren verarbeiten. Wird ein Gehäuse mit einem solchen Verfahren gefertigt, so weist es während der Fertigung einen Überstand an der Stelle auf, an dem das Material, aus dem das Gehäuse gefertigt wurde, in die Form eingespritzt wurde. Der Überstand wird während des Herstellungsverfahrens von dem Gehäuse abgetrennt, wobei ein Anspritzpunkt am Gehäuse ausgebildet wird. Bei dem Anspritzpunkt handelt es sich um jene Stelle, an dem der Überstand zuvor mit dem Gehäuse verbunden war. Dieser Anspritzpunkt ist ein charakteristisches Merkmal dafür, dass das Gehäuse mittels eines Spritzguss- oder Spritzpressverfahrens hergestellt wurde. Bei dem Anspritzpunkt kann es sich beispielsweise um einen kleinen Überstand handeln oder aber auch um eine entsprechende Strukturierung der Oberfläche, die durch den Abtrennprozess des Überstandes auf der Oberfläche des Gehäuses entstanden ist. Durch den Anspritzpunkt kann man auch noch am fertigen optoelektronischen Bauelement feststellen, dass dieses mittels eines Spritzguss- oder Spritzpressverfahrens hergestellt wurde.

Mittels des Spritzgussverfahrens können kostengünstig hohe Stückzahlen in sehr guter Qualität hergestellt werden.

Beim Spritzpressverfahren ("transfer molding") kann der Duroplast mittels Kolben von einer beispielsweise beheizten Vorkammer über Verteilerkanäle in die Form eingespritzt werden, in der dieser dann unter Wärme und Druck aushärtet. Bei dem Einsatz von Duroplasten bietet dieses Verfahren den Vorteil, dass die Transportwege des Duroplasten kurz sind und ein Aushärten vor dem Einpressen in das Werkzeug vermieden werden kann. Der Druck beträgt beim Spritzpressverfahren vorzugsweise 5 bis 50 MPa. In einer weiteren Ausführungsform der Erfindung umfasst der Duroplast ein Material ausgewählt aus: Harnstoff-Formaldehydharz, Melamin-Formaldehydharz, ungesättigte Polyester (UP).

Diese drei Harze haben sich als besonders vorteilhaft herausgestellt. Sie weisen beide eine sehr gute Temperatur- und Strahlungsstabilität auf und lassen sich dennoch beide sehr gut mittels Spritzguss- oder Spritzpressverfahren verarbeiten. Des Weiteren haben diese Harze den Vorteil, dass sie sich weiß einfärben lassen. Dies ist dann besonders vorteilhaft, wenn ein Teilbereich des Gehäuses als Reflektor ausgeformt ist. Somit kann beispielsweise die Innenseite des Reflektors, welche dem strahlungsemittierenden Bauteil zugewandt ist, weiß eingefärbt werden. Durch die Einfärbung kann die Reflektivität dieses Teils des Gehäuses gesteigert werden, was zu einer höheren Lichtausbeute des optoelektronischen Bauelements führt. Die drei angeführten Harze weisen des Weiteren eine sehr gute Stabilität gegenüber Bestrahlung auf, was auch eine Bestrahlung von UV-Licht mit einschließt. Somit eignen sich Harze auch für die Fertigung von optoelektronischen Bauelementen, die strahlungsemittierende Bauteile aufweisen, die einen Wellenlängenbereich emittieren, der auch einen UV-Anteil aufweist. Duroplaste auf Melaminharzbasis sowie ungesättigte Polyester weisen des Weiteren eine sehr gute Steifigkeit und Oberflächenhärte aus. Dies verleiht dem Gehäuse eine besonders gute Beständigkeit gegenüber mechanischen Einwirkungen auf das Gehäuse. Hierdurch können mechanische Beschädigungen und Verformungen an der Oberfläche des Gehäuses reduziert werden, was unter anderem die Lebensdauer des Gehäuses erhöhen kann.

Aminoplaste weisen ein besonders gutes Fließverhalten auf, weshalb sie sich besonders gut für den Einsatz bei Spritzgussverfahren eignen. Hierdurch ist es beispielsweise möglich, beim Herstellungsverfahren mit niedrigeren Drücken zu arbeiten, als dies bei anderen Duroplasten notwendig ist. In einer weiteren Ausführungsform umfasst der Duroplast zusätzlich Fasern als Füllstoff.

Bei den Fasern kann es sich beispielsweise um Glasfasern oder auch Zellulosefasern handeln. Durch den Zusatz dieser Fasern in den Duroplasten werden vor allem die mechanischen Eigenschaften des Gehäuses verbessert. Die Stabilität des Gehäuses gegenüber Zug- und Scherspannungen kann durch die Fasern deutlich gesteigert werden. Die Fasern können mit ihrer Länge auf die jeweiligen Anforderungen angepasst werden.

In einer weiteren Ausführungsform der Erfindung umfasst der Duroplast zusätzlich als Füllstoff ein Material ausgewählt aus: Mineralfüllstoff, Titandioxid.

Das Titandioxid kann beispielsweise dafür verwendet werden, das Gehäuse beziehungsweise Teilbereiche des Gehäuses einzufärben. Durch das Einfärben kann beispielsweise die Reflektivität und die Strahlungsbeständigkeit des Gehäuses erhöht werden.

Durch den Zusatz von Mineralfüllstoffen zu dem Duroplasten kann beispielsweise dessen Temperaturbeständigkeit erhöht werden. Es können aber auch eine erhöhte mechanische und/oder elektrische Festigkeit erzielt werden, wie eine verbesserte Kriechstromfestigkeit. Der Mineralfüllstoff kann beispielsweise in Pulver- oder in Plättchenform zugesetzt werden.

Bei dem Mineralfüllstoff kann es sich beispielsweise um Wollastonit handeln, einem faserförmigen Mineralfüllstoff. Dieser verbessert die mechanischen Eigenschaften des Duroplasten. Es kann sich beispielsweise auch um Kreide, CaCO₃, handeln, welche die Oberflächenbeschaffenheit sowie die mechanischen Eigenschaften verbessert.

In einer weiteren Ausführungsform der Erfindung umfasst der Duroplast zusätzlich als Füllstoff ein Material, welches die Strahlung, die von dem strahlungsemittierenden Bauteil emittiert wird, reflektiert.

Dadurch, dass der Duroplast ein solches Material umfasst, kann die Reflektivität bezüglich der Strahlung, die vom strahlungsemittierenden Bauteil emittiert wird, erhöht werden. Hierdurch kann die Lichtausbeute des optoelektronischen Bauelements gesteigert werden. Gleichzeitig wird der Anteil der Strahlung, der in das Gehäuse eindringt, reduziert, wodurch Beschädigungen durch die Strahlung vermindert werden. Der Füllstoff kann hierbei direkt auf den Wellenbereich abgestimmt werden, der von dem strahlungsemittierenden Bauteil emittiert wird.

In einer weiteren Ausführungsform der Erfindung handelt es sich bei dem strahlungsemittierenden Bauteil um eine LED. Das optoelektronische Bauelement kann auch mehr als eine Ausnehmung in dem Gehäuse aufweisen, und somit auch mehrere LEDs, welche jeweils in einer Ausnehmung angeordnet sein können. Es können auch in der gleichen Ausnehmung mehrere LEDs angeordnet sein.

In einer weiteren Ausführungsform der Erfindung handelt es sich bei dem strahlungsemittierenden Bauteil um eine organische LED, eine OLED.

In einer weiteren Ausführungsform der Erfindung ist das Gehäuse aus dem Duroplasten geformt.

Hierunter ist zu verstehen, dass das gesamte Gehäuse aus einem Aminoplast-Duroplast zusammen mit einem der folgenden Duroplasten: Harnstoff-Duroplast, Melamin-Formaldehyd-Duroplast, Feuchtpolyester-Duroplaste, Polyesterharz, Das Gehäuse weist hierbei insbesondere keine Anteile von Thermoplasten auf, wie auch keine Anteile von Duroplasten, welche obenstehend nicht angeführt wurden.

Neben dem optoelektronischen Bauelement wird auch ein Verfahren zu dessen Herstellung beansprucht.

Eine Variante zur Herstellung eines optoelektronischen Bauelements, wie es zuvor beschrieben wurde, umfasst die Verfahrensschritte:
- Ausformen eines Gehäuses, das einen Duroplasten umfasst, und eine Ausnehmung aufweist mittels Spritzguss- oder Spritzpressverfahrens als Verfahrensschritt A),
- Aushärten des Duroplasten als Verfahrensschritt B),
- Abtrennen des Überstandes, welcher durch das Spritzguss- oder Spritzpressverfahren vorhanden ist, so dass der Anspritzpunkt ausgebildet wird als Verfahrensschritt C),
- Einbringen des strahlungsemittierenden Bauteils in die Ausnehmung als Verfahrensschritt D),
wobei im Verfahrensschritt A) ein Duroplast verwendet wird, der einen Aminoplasten umfasst und zusätzlich ein Material ausgewählt aus: Harnstoff-Duroplast, Melamin-Formaldehyd-Duroplast, Feuchtpolyester-Duroplaste, Polyesterharz, Durch geeignete Auswahl der Duroplasten für das Gehäuse ist es möglich, dieses mittels Spritzguss- oder Spritzpressverfahrens auszuformen. Hierdurch weist das Gehäuse einen Überstand auf, der im Verfahrensschritt C) abgetrennt wird, sodass ein Anspritzpunkt ausgebildet ist. Anhand dieses Anspritzpunktes kann auch noch am fertigen Bauelement festgestellt werden, dass das Gehäuse des optoelektronischen Bauelements mittels Spritzguss- oder Spritzpressverfahrens gefertigt wurde.

In einer weiteren Variante des Verfahrens ist der Zylinder der Einfüllvorrichtung während des Spritzgießens oder Spritzpressens temperiert.

Beim Spritzguss und Spritzpressen von Duroplasten ist die Kontrolle der Temperatur während des Prozesses von Vorteil, damit es nicht schon während des Einspritzens bzw. Eingießvorgangs in der Einfüllvorrichtung zur Vernetzung und somit zur Aushärtung des Duroplasten kommt. Dies könnte eine Verstopfung der Vorrichtung zur Folge haben, womit der Prozess zum Erliegen käme. Die optimale Temperatur beziehungsweise der optimale Temperaturbereich ist hierbei auf den verwendeten Duroplasten abzustimmen.

In einer weiteren Variante des Verfahrens wird der Zylinder auf eine Temperatur von 60 °C bis 80 °C temperiert.

Eine Temperatur innerhalb dieses Temperaturbereichs ist für die meisten der angegebenen Duroplasten geeignet. Hierdurch wird sichergestellt, dass es nicht bereits im Zylinder zur Aushärtung des Duroplasten kommt.

In einer weiteren Variante des Verfahrens erfolgt im Verfahrensschritt A) das Ausformen mittels Spritzgussverfahrens.

Mittels Spritzgussverfahrens können kostengünstig hohe Stückzahlen in sehr guter Qualität hergestellt werden.

In einer weiteren Variante des Verfahrens wird im Verfahrensschritt A) mit einem Druck von größer 100 MPa gearbeitet.

Beim Spritzgussverfahren liegt der Druck vorzugsweise in einem Bereich von 100 bis 150 MPa. Neben der Temperatur stellt der Druck einen weiteren wichtigen Parameter im Verfahren dar. Über den Druck wird beispielsweise sichergestellt, dass das Spritzgut mit einer ausreichenden Geschwindigkeit durch die Vorrichtung gedrückt wird. Auch dies trägt dazu bei, dass es nicht zu einer vorzeitigen Aushärtung des Spritzgutes in der Vorrichtung kommt. Des Weiteren wird über den Druck auch sichergestellt, dass die Form, in die das Material für das Gehäuse eingespritzt wird, auch vollständig und ohne äußere und innere Ausnehmungen mit dem Material ausgefüllt wird.

Des Weiteren wird über den Druck auch sichergestellt, dass der Einspritzvorgang mit einer ausreichenden Geschwindigkeit erfolgt. Dies stellt zum einen wiederum sicher, dass es nicht schon zu einer vorzeitigen Aushärtung des Duroplasten während des Einspritzvorgangs kommt, zum anderen ermöglicht es, dass innerhalb von kurzer Zeit eine Vielzahl von Gehäusen gefertigt werden können.

In einer weiteren Variante des Verfahrens wird die Form, in welcher der Duroplast im Verfahrensschritt B) aushärtet, während des Aushärtens auf eine Temperatur von 150 °C bis 250 °C gehalten.

Dieser Temperaturbereich eignet sich für die meisten der oben angeführten Duroplasten. Bei dem Spritzguss- und Spritzpressverfahren ist das Temperieren der Form gerade beim Einsatz von Duroplasten von Vorteil. Da der Duroplast im Gegensatz zum Thermoplast eine dreidimensionale, vernetzte Struktur aufweist, ist es wichtig, dass eben jene Vernetzung im gesamten Gehäuse gleichmäßig und gleichförmig vonstatten geht, sodass sichergestellt werden kann, dass das Gehäuse in sich eine einheitliche Stabilität aufweist. Würden beispielsweise zwei Teilbereiche des Gehäuses einen sehr hohen Vernetzungsgrad aufweisen und der Bereich, der zwischen diesen beiden Teilbereichen liegt, nur einen sehr niedrigen Vernetzungsgrad, so könnte es sehr leicht zu Brüchen des Gehäuses in dem Bereich mit der niedrigen Vernetzung kommen. Hierzu ist es beispielsweise wichtig, dass erst die gesamte Form mit dem Material für das Gehäuse ausgefüllt ist, bevor der Vernetzungsprozess in einem Teilbereich des Gehäuses bereits abgeschlossen ist. Die Vernetzungsgeschwindigkeit wie auch der Grad der Vernetzung kann somit unter anderem durch die Temperatur der Form gesteuert werden. Die exakte Temperatur kann hierbei auf den verwendeten Duroplasten, wie auch auf den angestrebten Vernetzungsgrad abgestellt werden.

In einer weiteren Variante des Verfahrens findet während des Aushärtens im Verfahrensschritt B) eine Vernetzung des Duroplasten statt.

Wie bereits ausgeführt, ist die Vernetzung maßgeblich für die charakteristischen Eigenschaften des Duroplasten verantwortlich, wie beispielsweise seine Stabilität gegenüber Strahlung und hohen Temperaturen. Durch die Vernetzung unterscheidet sich auch der Duroplast maßgeblich von anderen Stoffgruppen, wie beispielsweise den Thermoplasten, die in der Regel nicht vernetzt sind. Eine hohe Temperaturbeständigkeit des Duroplasten macht es beispielsweise möglich, dass das Gehäuse, welche aus einem Material gefertigt ist, das einen solchen Duroplasten umfasst, auch höheren Temperaturen unterworfen werden kann, ohne dass es zu Beschädigung oder Verfärbung des Gehäuses kommt. Dies kann man sich beispielsweise in einem Lötprozess zunutze machen. So kann beispielsweise das Gehäuse mittels eines Lötprozesses mit einem anderen Bauteil verbunden werden.

In einer weiteren Variante des Verfahrens wird im Verfahrensschritt D) eine LED als strahlungsemittierendes Bauteil verwendet. Es sind auch Varianten des Verfahrens denkbar, in denen eine organische LED, eine OLED, verwendet wird.

Im Folgenden sollen Varianten der Erfindung anhand von Figuren und Ausführungsbeispielen näher erläutert werden.
- Figur 1: zeigt einen schematischen Querschnitt durch eine erste erfindungsgemäße Ausführungsform des optoelektronischen Bauelements,
- Figur 2: zeigt einen schematischen Querschnitt durch eine zweite erfindungsgemäße Ausführungsform des optoelektronischen Bauelements.

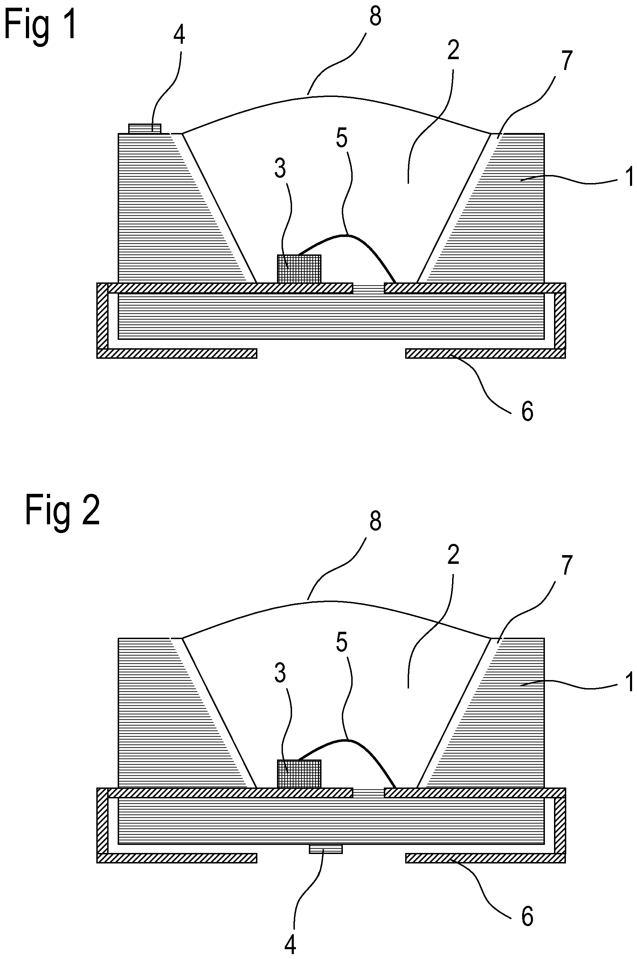

Die Figur 1 zeigt ein erfindungsgemäßes optoelektronisches Bauelement im schematischen Querschnitt. Dieses umfasst ein Gehäuse 1, welches einen der zuvor genannten Duroplasten umfasst. Im dargestellten Ausführungsbeispiel ist das gesamte Gehäuse 1 aus dem Duroplasten ausgeformt. Somit werden durch den Duroplasten die physikalischen und chemischen Eigenschaften des Gehäuses bestimmt. Hiermit weist das Gehäuse 1 eine sehr hohe Beständigkeit in Bezug auf Wärme, Bestrahlung wie auch mechanische Beschädigungen auf. Das Gehäuse 1 weist eine Ausnehmung 2 auf, in der das strahlungsemittierende Bauteil 3 angeordnet ist. Das strahlungsemittierende Bauteil 3 ist sowohl mechanisch wie auch elektrisch leitend mit dem ersten Teil des Leiterrahmens 6 verbunden. Das strahlungsemittierende Bauteil 3 ist zusätzlich elektrisch leitend über den Bonddraht 5 mit dem zweiten Teil des Leiterrahmens 6 verbunden. Die Innenseite des Gehäuses 1, welche der Ausnehmung 2 zugewandt ist, ist als Reflektor 7 ausgeformt. Der Reflektor 7 weist eine höhere Reflektivität bezüglich der Strahlung auf, welche von dem strahlungsemittierenden Bauteil 3 emittiert wird, als der Rest des Gehäuses 1. Die Ausnehmung 2 ist mit einem Verguss ausgegossen, welcher an der Strahlungsaustrittsfläche als Linse 8 ausgeformt ist. Das Gehäuse 1 kann insbesondere undurchlässig für die vom Bauteil 3 emittierte Strahlung sein.

In Zusammenhang mit dieser Erfindung ist der Verguss, welcher sich in der Ausnehmung 2 des Gehäuses 1 befindet, nicht als Bestandteil des Gehäuses anzusehen, sondern lediglich als Bestandteil des optoelektronischen Bauelements insgesamt.

Das in Figur 1 dargestellte Ausführungsbeispiel weist an seiner Oberseite einen Anspritzpunkt 4 auf. In diesem Ausführungsbeispiel ist der Anspritzpunkt 4 als ein kleiner Überstandsrest ausgeformt. Dieser Anspritzpunkt 4 ist ein charakteristisches Merkmal dafür, dass das Gehäuse 1 mittels einer Spritzguss- oder Spritzpress-Technik ausgeformt wurde. Anhand des Anspritzpunktes 4 kann auch an dem fertigen optoelektronischen Bauelement noch klar festgestellt werden, dass dieses mittels eines Spritzguss- oder Spritzpressverfahrens hergestellt wurde. An der Lage des Anspritzpunktes 4 ist zu erkennen, dass die Spritzguss- bzw. Spritzpressform von der Oberseite her mit dem Material befüllt worden ist. Durch das Abtrennen des Überstandes ist der Anspritzpunkt 4 entstanden.

Die Figur 2 zeigt ein Ausführungsbeispiel, welches weitgehend jedem Ausführungsbeispiel entspricht, wie es in Figur 1 dargestellt ist. Das Ausführungsbeispiel, welches in Figur 2 dargestellt ist, weist jedoch einen Anspritzpunkt 4 auf, welcher sich an der Unterseite des Gehäuses 1 befindet. Dies ist ein Hinweis dafür, dass das Gehäuse 1 über Kopf gefertigt wurde. Die Form wurde praktisch auf dem Kopf stehend von der späteren Unterseite des Gehäuses 1 mit dem Material befüllt, welches das Gehäuse 1 ausbildet. Auch hier ist der Anspritzpunkt 4 wieder durch das Abtrennen des Überstandes ausgebildet worden.

Der Anspritzpunkt 4 kann sich auch an anderen Orten des Gehäuses 1 befinden, als in den Figuren 1 oder 2 dargestellt. Des Weiteren kann der Anspritzpunkt 4 auch eine andere Gestalt haben als in diesen beiden Ausführungsbeispielen dargestellt. So kann es sich bei dem Anspritzpunkt 4 auch um beispielsweise um eine Strukturierung der Oberfläche des Gehäuses 1 handeln, die beispielsweise durch ein nachträgliches Abschleifen des noch überstehenden Materials resultieren kann. Es kann sich beispielsweise auch um eine Verformung handeln, die aus einer nachträglichen thermischen Behandlung jenes Bereiches resultiert, an dem noch ein Materialüberstand am Gehäuse zurückgeblieben ist, welcher nachträglich beispielsweise abgeschmolzen wurde.

## Patentansprüche

1. Optoelektronisches Bauelement umfassend,
- ein Gehäuse (1), umfassend einen Duroplasten,
- eine Ausnehmung (2) in dem Gehäuse (1),
- ein strahlungsemittierendes Bauteil (3), welches in der Ausnehmung (2) angeordnet ist,
wobei der Duroplast ein Material umfasst ausgewählt aus:
Harnstoff-Duroplast, Melamin-Formaldehyd-Duroplast, Feuchtpolyester-Duroplaste, Polyesterharz, und
wobei das optoelektronische Bauelement einen Anspritzpunkt (4) aufweist,
wobei der Duroplast einen Aminoplast umfasst,
wobei das Gehäuse keine Anteile von Thermoplasten aufweist, und
wobei das Gehäuse keine Anteile von Duroplasten aufweist, welche obenstehend nicht aufgeführt sind.

2. Optoelektronisches Bauelement nach Anspruch 1,
wobei der Duroplast ein Material umfasst ausgewählt aus:
Harnstoff-Formaldehydharz, Melamin-Formaldehydharz,
ungesättigte Polyesterharze.

3. Optoelektronisches Bauelement nach einem der vorhergehenden Ansprüche,
wobei der Duroplast zusätzlich Fasern als Füllstoff umfasst.

4. Optoelektronisches Bauelement nach einem der vorhergehenden Ansprüche,
wobei der Duroplast zusätzlich als Füllstoff ein Material umfasst ausgewählt aus: Mineralfüllstoffe, Titandioxid.

5. Optoelektronisches Bauelement nach einem der vorhergehenden Ansprüche,
wobei der Duroplast zusätzlich als Füllstoff ein Material umfasst, welches die Strahlung, die von dem strahlungsemittierenden Bauteil (3) emittiert wird, reflektiert.

6. Optoelektronisches Bauelement nach einem der vorhergehenden Ansprüche,
wobei es sich bei dem strahlungsemittierenden Bauteil (3) um eine LED handelt.

7. Optoelektronisches Bauelement nach einem der vorhergehenden Ansprüche,
wobei das Gehäuse (1) aus dem Duroplasten geformt ist.

8. Verfahren zur Herstellung eines optoelektronischen Bauelements nach einem der Ansprüche 1 bis 7 umfassend die Verfahrensschritte:
A) Ausformen eines Gehäuses (1), welches einen Duroplasten umfasst und eine Ausnehmung (2) aufweist mittels Spritzguss- oder Spritzpressverfahrens,
B) Aushärten des Duroplasten,
C) Abtrennen des Überstandes, welcher durch das Spritzguss- oder Spritzpressverfahren vorhanden ist, so dass der Anspritzpunkt (4) ausgebildet wird,
D) Einbringen des strahlungsemittierenden Bauteils (3) in die Ausnehmung (2),
wobei im Verfahrensschritt A) ein Duroplast verwendet wird, das einen Aminoplasten umfasst und zusätzlich ein Material ausgewählt aus: Harnstoff-Duroplast, Melamin-Formaldehyd-Duroplast, Feuchtpolyester-Duroplaste, Polyesterharz.

9. Verfahren nach Anspruch 8,
wobei der Zylinder der Einfüllvorrichtung während des Spritzgießens oder Spritzpressens temperiert ist.

10. Verfahren nach Anspruch 9,
wobei der Zylinder auf eine Temperatur von 60 °C bis 80 °C temperiert wird.

11. Verfahren nach einem der Ansprüche 8 bis 10,
wobei im Verfahrensschritt A) das Ausformen mittels Spritzgussverfahrens erfolgt.

12. Verfahren nach Anspruch 11,
wobei im Verfahrensschritt A) mit einem Druck von größer 100 MPa gearbeitet wird.

13. Verfahren nach einem der Ansprüche 8 bis 12,
wobei die Form, in welcher der Duroplast im Verfahrensschritt B) aushärtet, während des Aushärtens auf einer Temperatur von 150 °C bis 250 °C gehalten wird.

14. Verfahren nach einem der Ansprüche 8 bis 13,
wobei während des Aushärtens im Verfahrensschritt B) eine Vernetzung des Duroplasten stattfindet.

## Claims

1. An optoelectronic component comprising
- a housing (1), comprising a thermosetting plastic,
- a recess (2) in the housing (1),
- a radiation-emitting component (3) which is arranged in the recess (2),
wherein the thermosetting plastic comprises a material selected from: urea thermosetting plastic, melamine-formaldehyde thermosetting plastic, moist polyester, polyester resin, and
wherein the optoelectronic component comprises a gate mark (4),
wherein the thermosetting plastic comprises an aminoplast,
wherein the housing possesses no fractions of thermoplastics and no further fractions of thermosetting plastics other than those listed above.

2. The optoelectronic component according to claim 1, wherein the thermosetting plastic comprises a material selected from: urea-formaldehyde resin, melamine-formaldehyde resin, unsaturated polyester resins.

3. The optoelectronic component according to one of the preceding claims,
wherein the thermosetting plastic further comprises fibers as a filler.

4. The optoelectronic component according to one of the preceding claims,
wherein the thermosetting plastic additionally comprises, as a filler, a material selected from: mineral fillers, titanium dioxide.

5. The optoelectronic component according to one of the preceding claims,
wherein the thermosetting plastic further comprises, as a filler, a material which reflects the radiation emitted by the radiation-emitting component (3).

6. The optoelectronic component according to one of the preceding claims,
wherein the radiation-emitting component is an LED.

7. The optoelectronic component according to one of the preceding claims,
wherein the housing is molded from the thermosetting plastic.

8. A method for producing an optoelectronic component according to one of claims 1 to 7, comprising the following method steps:
A) molding a housing comprising a thermosetting plastic and having a recess (2) by means of an injection molding or transfer molding process,
B) curing the thermosetting plastic,
C) detaching a projection present as a result of the injection molding or transfer molding process such that the gate mark is formed, and
D) introducing the radiation-emitting component into the recess,
wherein in method step A) a thermosetting plastic is used which comprises an aminoplast and additionally a material selected from: urea thermosetting plastic, melamine-formaldehyde thermosetting plastic, moist polyester, polyester resin.

9. The method according to claim 8,
wherein the temperature of the cylinder of the feeding device is controlled during the injection molding or transfer molding.

10. The method according to claim 9,
wherein the cylinder is tempered to a temperature of 60°C to 80°C.

11. The method according to one of claims 8 to 10,
wherein in method step (A) the molding is done by means of the injection molding method.

12. The method according to claim 11,
wherein (A) is carried out at a pressure of greater than 100 MPa.

13. The method according to one of claims 8 to 12,
wherein a mould in which the thermosetting plastic cures in (B) is held at a temperature ranging from 150°C to 250°C during curing.

14. The method according to one of claims 8 to 13,
wherein crosslinking of the thermosetting plastic takes place during the curing in (B).

## Revendications

1. Dispositif optoélectronique comprenant
- un boîtier (1) comprenant une résine thermodurcissable,
- un évidement (2) dans le boîtier (1),
- un composant (3) émetteur de rayonnement, lequel est disposé dans l'évidement (2),
la résine thermodurcissable comprenant une matière sélectionnée à partir des groupes : résine thermodurcissable d'urée, résine thermodurcissable de mélamine formaldéhyde, résines thermodurcissables de polyester humide, résine de polyester, et
le dispositif optoélectronique présentant un point d'injection (4),
la résine thermodurcissable comprenant un aminoplaste, le boitier ne présentant pas un pourcentage de thermoplastiques,
et
le boîtier ne présentant pas de pourcentages de résines thermodurcissables qui ne sont pas mentionnés plus haut.

2. Dispositif optoélectronique selon la revendication 1, la résine thermodurcissable comprenant une matière sélectionnée à partir des groupes : résine d'urée formaldéhyde, résine de mélamine formaldéhyde, résines de polyester non saturées.

3. Dispositif optoélectronique selon l'une quelconque des revendications précédentes,
la résine thermodurcissable comprenant en plus des fibres en tant que matière de remplissage.

4. Dispositif optoélectronique selon l'une quelconque des revendications précédentes,
la résine thermodurcissable comprenant en plus, en tant que matière de remplissage, une matière sélectionnée dans les groupes : matières de remplissage minérales, dioxyde de titane.

5. Dispositif optoélectronique selon l'une quelconque des revendications précédentes,
la résine thermodurcissable comprenant en plus, en tant que matière de remplissage, une matière qui réfléchit le rayonnement émis par le composant (3) émetteur de rayonnement.

6. Dispositif optoélectronique selon l'une quelconque des revendications précédentes,
le composant (3) émetteur de rayonnement étant une LED.

7. Dispositif optoélectronique selon l'une quelconque des revendications précédentes,
le boîtier (1) étant formé à partir de la résine thermodurcissable.

8. Procédé de fabrication d'un dispositif optoélectronique selon l'une quelconque des revendications 1 à 7, comprenant les étapes de procédé,
A) formage, par procédé de moulage par injection ou par procédé de moulage par pressage, d'un boîtier (1) qui comprend une résine thermodurcissable et présente un évidement (2),
B) durcissement de la résine thermodurcissable,
C) séparation de l'excès qui est présent en raison du procédé de moulage par injection ou du procédé de moulage par pressage, de sorte à réaliser le point d'injection (4),
D) insertion dans l'évidement (2) du composant (3) émetteur de rayonnement,
une résine thermodurcissable étant utilisé à l'étape A) du procédé, laquelle résine comprend un aminoplaste et en plus une matière sélectionnée à partir des groupes : résine thermodurcissable d'urée, résine thermodurcissable de mélamine formaldéhyde, résines thermodurcissables de polyester humide, résine de polyester.

9. Procédé selon la revendication 8,
le cylindre du dispositif de remplissage étant tempéré pendant le moulage par injection ou le moulage par pressage.

10. Procédé selon la revendication 9,
le cylindre étant tempéré à une température de 60° C à 80° C.

11. Procédé selon l'une quelconque des revendications 8 à 10,
le formage, à l'étape A) du procédé étant réalisé par procédé de moulage par injection.

12. Procédé selon la revendication 11,
une pression supérieure à 100 MPa étant utilisée à l'étape A) du procédé.

13. Procédé selon l'une quelconque des revendications 8 à 12,
le moule dans lequel la résine thermodurcissable durcit à l'étape de procédé B) étant maintenu à une température de 150° C à 250° C pendant le durcissement.

14. Procédé selon l'une quelconque des revendications 8 à 13,
une réticulation de la résine thermodurcissable ayant lieu pendant le durcissement à l'étape de procédé B).
